# EUROPEAN PATENT APPLICATION

(11) **EP 4 811 519 A1**
(43) Date of publication of application: **23.09.2026**
(21) Application number: 24895649.2
(22) Date of filing: 10.07.2024
(51) Int. Cl.: H01M 50/244, A62C 31/28, H01M 50/204, A62C 31/00

(54) **THERMAL RUNAWAY MANAGEMENT SYSTEM, COMPUTING DEVICE CLUSTER, AND DATA CENTER**

(30) Priority: 29.11.2023 CN 202311616045; 08.05.2024 CN 202410564500
(71) Applicant: Huawei Cloud Computing Technologies Co., Ltd., Gui'an New District, Guizhou 550025 (CN)
(72) Inventor: CAO, Hanwen, Shenzhen, Guangdong 518129 (CN); ZOU, Henglong, Shenzhen, Guangdong 518129 (CN); YAO, Xidong, Shenzhen, Guangdong 518129 (CN); CHEN, Lv, Shenzhen, Guangdong 518129 (CN)
(74) Representative: Pfenning, Meinig & Partner mbB
(86) International application number: PCT/CN2024/104641
(87) International publication number: WO 2025/112546

(57) **Abstract**

This application provides a thermal runaway management system, a compute device cluster, and a data center. The thermal runaway management system is disposed in the compute device cluster. The compute device cluster includes at least one cabinet, at least one energy storage apparatus is disposed in each cabinet, and at least one energy storage unit is disposed in each energy storage apparatus. The thermal runaway management system includes a storage apparatus, a transmission assembly, and a control assembly. A cooling medium is stored in the storage apparatus. The transmission assembly includes a main pipe, where the main pipe is connected to the storage apparatus, at least one main connecting pipe is connected to the main pipe, at least one sub connecting pipe is connected to each main connecting pipe, and the sub connecting pipe is connected to the energy storage unit. The control assembly is disposed on the transmission assembly, and the control assembly is at least partially disposed inside the energy storage unit, to allow the cooling medium to enter the energy storage unit through the transmission assembly when an ambient temperature of the energy storage unit is higher than or equal to a thermal runaway temperature of the energy storage unit.

## Description

This application claims priorities to Chinese Patent Application No. 202311616045.7, filed with the China National Intellectual Property Administration on November 29, 2023 and entitled "THERMAL RUNAWAY HANDLING APPARATUS FOR ENERGY STORAGE SYSTEM", and to Chinese Patent Application No. 202410564500.1, filed with the China National Intellectual Property Administration on May 8, 2024 and entitled "THERMAL RUNAWAY MANAGEMENT SYSTEM, COMPUTE DEVICE CLUSTER, AND DATA CENTER", both of which are incorporated herein by reference in their entireties.

### TECHNICAL FIELD

This application relates to the field of data center technologies, and specifically, to a thermal runaway management system, a compute device cluster, and a data center.

### BACKGROUND

With the development of network and communication technologies, a large quantity of compute device clusters are deployed in a data center equipment room, and devices in the compute device clusters include physical servers, virtual machines, distributed compute nodes, or the like. Some energy storage units, for example, batteries, are usually disposed in the data center equipment room as backup power supplies for the devices in the data center equipment room. During use of the batteries, a battery temperature may easily increase sharply due to a factor like overcharging or extrusion, and reach a thermal runaway temperature of the batteries, causing thermal runaway, and leading to fire or even explosion. This greatly reduces use safety of the data center.

Once thermal runaway occurs in the data center, in a conventional technology, a fire extinguishing medium is usually used to cool the data center from the outside. However, in an external cooling manner, only an open flame generated by the thermal runaway in the data center can be extinguished, and thermal runaway of the batteries inside the data center and out-of-control propagation of the batteries inside the data center cannot be effectively controlled.

### SUMMARY

In view of this, this application provides a thermal runaway management system, a compute device cluster, and a data center, to control a temperature in the data center in an early stage or an early to middle stage of thermal runaway of the data center, and prevent or slow down occurrence of the thermal runaway, preventing spread of the thermal runaway. This minimizes an asset loss of the data center.

According to a first aspect, an embodiment of this application provides a thermal runaway management system, where the thermal runaway management system is disposed in a compute device cluster, the compute device cluster includes at least one cabinet, at least one energy storage apparatus is disposed in each cabinet, each energy storage apparatus includes at least one energy storage unit, and the thermal runaway management system includes:
a storage apparatus, where the storage apparatus stores a cooling medium;
a transmission assembly, where the transmission assembly includes a main pipe, the main pipe is connected to the storage apparatus, at least one main connecting pipe is connected to the main pipe, the main connecting pipe and the energy storage apparatus are in one-to-one correspondence, at least one sub connecting pipe is connected to each main connecting pipe, the sub connecting pipe and the energy storage unit are in one-to-one correspondence, and the sub connecting pipe is connected to the energy storage unit; and
a control assembly, where the control assembly is disposed on the transmission assembly, and the control assembly is at least partially disposed inside the energy storage unit, to allow the cooling medium to enter the energy storage unit through the transmission assembly when an ambient temperature of the energy storage unit is higher than or equal to a thermal runaway temperature of the energy storage unit.

In the foregoing solution, the thermal runaway management system in this application is mainly disposed in the compute device cluster, and can be configured to prevent or handle a risk of thermal runaway occurring in the energy storage unit in the compute device cluster, and further avoid out-of-control propagation of the energy storage unit. Specifically, in this application, the transmission assembly is directly connected to each energy storage unit. The control assembly is at least partially disposed inside the energy storage unit to detect the ambient temperature of the energy storage unit. The control assembly is disposed on the transmission assembly, to allow the cooling medium to enter the energy storage unit through the transmission assembly when the ambient temperature of the energy storage unit is higher than or equal to the thermal runaway temperature of the energy storage unit. The cooling medium exchanges heat with heat generated inside the energy storage unit, to handle thermal runaway of the energy storage unit. Therefore, the temperature of the energy storage unit is reduced, the risk of thermal runaway occurring in the energy storage unit is avoided, and a risk of fire or even explosion of the energy storage unit is reduced. Further, thermal runaway propagation of the energy storage unit to surrounding energy storage units and cabinets is avoided. This effectively blocks the thermal runaway propagation, and reduces a risk of thermal runaway of the compute device cluster. It may be understood that the thermal runaway of the energy storage unit is a phenomenon that the temperature in the energy storage unit increases sharply due to chemical reaction runaway. The thermal runaway temperature of the energy storage unit is a critical temperature at which the thermal runaway is about to occur in the energy storage unit. When the ambient temperature of the energy storage unit is higher than or equal to the thermal runaway temperature of the energy storage unit, it indicates that the thermal runaway is about to occur in the energy storage unit. According to the thermal runaway management system in this application, the control assembly can be configured to detect the ambient temperature in the energy storage unit, can further control the cooling medium to enter the energy storage unit through the transmission assembly, and can handle thermal runaway in an initial stage or re-ignition of any energy storage unit in time, so that thermal runaway and thermal runaway propagation of the energy storage unit can be effectively suppressed, and a fire can be extinguished in time, thereby improving use safety of the compute device cluster.

In some possible implementations, when the ambient temperature of the energy storage unit is lower than the thermal runaway temperature of the energy storage unit, the control assembly enables the transmission assembly to be in a closed state; or
when the ambient temperature of the energy storage unit is higher than or equal to the thermal runaway temperature of the energy storage unit, the control assembly enables the transmission assembly to be in an open state.

In the foregoing solution, the control assembly is disposed to detect the ambient temperature of the energy storage unit and adjust a status of the transmission assembly, to enable the transmission assembly to be in the open state or the closed state. When the ambient temperature of the energy storage unit and detected by the control assembly is lower than the thermal runaway temperature of the energy storage unit, it indicates that the energy storage unit is in a normal state, and thermal runaway does not occur. In this case, the control assembly is in the closed state, and the cooling medium in the storage apparatus cannot be in communication with the inside of the energy storage unit through the transmission assembly. When the ambient temperature detected by the control assembly is higher than or equal to the thermal runaway temperature of the energy storage unit, it indicates that the energy storage unit has a risk of thermal runaway or thermal runaway has occurred. In this case, the control assembly is in the open state, so that the cooling medium in the storage apparatus can be in communication with the inside of the energy storage unit through the transmission assembly, and exchange heat with the heat generated inside the energy storage unit. Therefore, the temperature of the energy storage unit is reduced, the risk of thermal runaway occurring in the energy storage unit is avoided, and a risk of fire or even explosion of the energy storage unit is reduced. Further, thermal runaway propagation of the energy storage unit to surrounding energy storage units and cabinets is avoided. This effectively blocks the thermal runaway propagation, and reduces the risk of thermal runaway.

In some possible implementations, the control assembly includes a fire-trace tube and a container valve, the container valve is disposed on the sub connecting pipe, one end of the fire-trace tube is connected to the container valve, and the other end of the fire-trace tube is disposed inside the energy storage unit.

In the foregoing solution, in this application, a combination of the container valve and the fire-trace tube is used as the control assembly. A fire detection material is disposed in the fire-trace tube, and can expand and burst upon being heated at a specific temperature. In this application, a burst temperature of the fire-trace tube is set to the thermal runaway temperature of the energy storage unit. The container valve is mounted on the sub connecting pipe and is used as a valve for controlling the sub connecting pipe to be open or closed. The container valve is in a closed state at a constant pressure. In this case, the sub connecting pipe is in a closed state. When the container valve is at a specific pressure, the container valve is open. In this case, the sub connecting pipe is in an open state. In an initial working process of the thermal runaway management system, the ambient temperature of the energy storage unit is low, and the ambient temperature is lower than the thermal runaway temperature of the energy storage unit. In this case, the fire-trace tube is in a normal non-burst state, the container valve is at the constant pressure, and the container valve is in the closed state. If the fire-trace tube bursts, it indicates that the energy storage unit has a risk of thermal runaway. In this case, a pressure in the fire-trace tube suddenly decreases, a pressure at an end of that is of the container valve and that is close to the fire-trace tube also decreases, and the container valve is open, to enable the sub connecting pipe to be in the open state, so that the cooling medium in the storage apparatus can enter the energy storage unit through the transmission assembly to handle the thermal runaway. In some embodiments, the thermal runaway temperature of the energy storage unit is set to 70°C.

In some possible implementations, the energy storage unit includes at least one cell group, the cell group includes at least one cell, and the fire-trace tube is disposed on a surface of the at least one cell.

In the foregoing solution, the fire-trace tube is disposed on the surface of the cell inside the energy storage unit, so that the fire-trace tube can directly detect a temperature of the cell, to obtain more precise thermal runaway information. This helps quickly transfer the cooling medium to the inside of the energy storage unit corresponding to the cell where thermal runaway occurs, to quickly handle thermal runaway. The cell is a smallest unit that can be independently used in the energy storage system, and cells are usually arranged inside the energy storage unit in regular rows and columns. Preferably, the fire-trace tube sequentially surrounds each cell group, and is disposed around surfaces of all cell modules in the cell group, to monitor temperatures of all cells in the energy storage unit.

In some possible implementations, the sub connecting pipe includes a first pipe and a second pipe that are connected to each other, the first pipe is disposed outside the energy storage unit, and the second pipe is disposed inside the energy storage unit.

In the foregoing solution, the sub connecting pipe in this application includes two parts of pipes. One part of the pipes is disposed outside the energy storage unit, and the other part of the pipes is disposed inside the energy storage unit. In this way, the cooling medium can be directly transferred to the inside of the energy storage unit for heat exchange, thereby improving efficiency of handling thermal runaway. Preferably, because the control assembly enables the sub connecting pipe to be in the open state or the closed state, in this solution, the control assembly may enable the first pipe and the second pipe to be in a connected state or a disconnected state. When the first pipe and the second pipe are in the connected state, the sub connecting pipe is in the open state; or when the first pipe and the second pipe are in the disconnected state, the sub connecting pipe is in the closed state. The cooling medium in an initial state may be transmitted to the main pipe of the transmission assembly, the main connecting pipe, and the first pipe. If the ambient temperature of the energy storage unit is higher than or equal to the thermal runaway temperature of the energy storage unit, the control assembly enables the first pipe and the second pipe to be connected, that is, the sub connecting pipe is in the open state. In this case, the cooling medium in the first pipe can quickly reach the inside of the energy storage unit through the second pipe, to handle thermal runaway inside the energy storage unit. In this way, when thermal runaway occurs in the energy storage unit, a transmission distance and a transmission time length of the cooling medium can be shortened, thereby greatly improving efficiency of handling the thermal runaway of the energy storage unit.

In some possible implementations, the control assembly includes a temperature sensing element, and the temperature sensing element is disposed inside the second pipe.

When the ambient temperature of the energy storage unit is lower than the thermal runaway temperature of the energy storage unit, the temperature sensing element is sealed inside the second pipe, to enable the second pipe to be in a closed state.

When the ambient temperature of the energy storage unit is higher than or equal to the thermal runaway temperature of the energy storage unit, the temperature sensing element changes, to enable the second pipe to be in an open state.

In the foregoing solution, the temperature sensing element is used as the control assembly, and the temperature sensing element is disposed in the second pipe inside the energy storage unit. The temperature sensing element may be used as an element for detecting the temperature in the energy storage unit, and may be further used as an element for controlling whether the sub connecting pipe is open. In this way, when the thermal runaway management system initially works, the ambient temperature of the energy storage unit is lower than the thermal runaway temperature of the energy storage unit, and the cooling medium may be pre-transmitted to the main pipe of the transmission assembly, the main connecting pipe, the first pipe, and the second pipe connected to the first pipe. In other words, the cooling medium has entered the energy storage unit before thermal runaway occurs, and the cooling medium cannot flow out through the transmission assembly due to existence of the temperature sensing element. If the ambient temperature of the energy storage unit is higher than or equal to the thermal runaway temperature of the energy storage unit, the temperature sensing element changes, to enable the second pipe to be in the open state. In this case, the cooling medium can flow out of the second pipe and exchange heat with the inside of the energy storage unit, to handle the thermal runaway. In this application, the temperature sensing element is disposed to further shorten the transmission distance and the transmission time length of the cooling medium, thereby greatly improving the efficiency of handling the thermal runaway of the energy storage unit.

In some possible implementations, the temperature sensing element includes a temperature sensing glass ball and/or a shape memory alloy.

In the foregoing solution, the temperature sensing glass ball is sensitive to a temperature, and can burst when exposed to high-temperature radiation, to implement the open or closed state of the sub connecting pipe, detect the temperature of the energy storage unit, and control whether the cooling medium enters the energy storage unit. The temperature sensing glass ball may be customized with any temperature and diameter, and therefore, can be used for pipes with different functions and different diameters, to improve an application scenario of the temperature sensing element. The shape memory alloy is sensitive to a temperature, and can deform reversibly at different temperatures, to enable the sub connecting pipe to be in the open or closed state, detect the temperature of the energy storage unit, and control whether the cooling medium enters the energy storage unit. The shape memory alloy may be customized with any shape and deformation temperature, to improve the application scenario of the temperature sensing element.

In some possible implementations, the thermal runaway management system further includes a connector, the connector is disposed on the energy storage unit, and the sub connecting pipe and the energy storage unit are detachably connected through the connector.

In the foregoing solution, the connector is disposed, to enable the sub connecting pipe and the energy storage unit to be detachably connected, facilitating subsequent maintenance and management.

In some possible implementations, the thermal runaway management system further includes a control module and a first regulating valve, the control module is separately connected to the control assembly and the first regulating valve, and the first regulating valve is disposed on at least one of the main pipe, the main connecting pipe, and the sub connecting pipe.

In the foregoing solution, in this application, the control module and the first regulating valve are disposed in the thermal runaway management system. The first regulating valve may be, for example, a flow regulating valve. The control module controls an opening degree of the first regulating valve based on a change of the control assembly, to adjust a flow volume of transferring the cooling medium to the energy storage unit, avoiding untimely thermal runaway suppression or a waste of the cooling medium caused by abuse of the cooling medium. In the thermal runaway management system in this application, the transmission assembly is disposed in a distributed manner, and the storage apparatus stores the cooling medium in a centralized manner. The first regulating valve is disposed on at least one of the main pipe, the main connecting pipe, and the sub connecting pipe, to implement flow volume control on different pipes of the transmission assembly. In this way, thermal runaway suppression of the entire compute device cluster can be implemented by storing a small volume of cooling medium in the storage apparatus.

In some possible implementations, the thermal runaway management system further includes a temperature sensing module, the temperature sensing module is configured to detect an ambient temperature in any energy storage unit, and the temperature sensing module is connected to the control module.

In the foregoing solution, in this application, the temperature sensing module is disposed in the thermal runaway management system. The temperature sensing module is configured to precisely detect the temperature in the energy storage unit. The control module can adjust, based on the temperature detected by the temperature sensing module, the flow volume of transferring the cooling medium to the energy storage unit, improving precision of thermal runaway suppression, and avoiding untimely thermal runaway suppression or a waste of the cooling medium caused by abuse of the cooling medium.

In some possible implementations, the storage apparatus includes a liquid storage apparatus, the cooling medium is disposed in the liquid storage apparatus, and the liquid storage apparatus is connected to the main pipe.

In the foregoing solution, in this application, the liquid storage apparatus is disposed to store the cooling medium, and the cooling medium is pooled in a centralized manner. A volume of cooling medium for handling thermal runaway of only one or two energy storage units may be stored, thereby minimizing a needed storage volume of the cooling medium.

In some possible implementations, the storage apparatus further includes a gas storage apparatus, the gas storage apparatus and the liquid storage apparatus are connected to each other through a pipe, a second regulating valve is disposed on the pipe, there is a first pressure in the gas storage apparatus, there is a second pressure in the liquid storage apparatus, and the first pressure is higher than the second pressure.

In the foregoing solution, the gas storage apparatus is disposed to provide a driving force for transferring the cooling medium in the liquid storage apparatus to the transmission assembly. Specifically, there is the first pressure in the gas storage apparatus, there is the second pressure in the liquid storage apparatus, the first pressure is higher than the second pressure, and a pressure difference between the first pressure and the second pressure enables the cooling medium in the liquid storage apparatus to be actively transferred to the transmission assembly. In some embodiments, there is a pressure in the gas storage apparatus, and there is no pressure in the liquid storage apparatus. In some other embodiments, there is a pressure in the gas storage apparatus, there is also a pressure in the liquid storage apparatus, and the pressure in the gas storage apparatus is higher than the pressure in the liquid storage apparatus.

In some possible implementations, a liquid delivery apparatus is disposed on the main pipe, and the liquid delivery apparatus is configured to extract the cooling medium in the storage apparatus.

In the foregoing solution, the liquid delivery apparatus may actively extract the cooling medium in the liquid storage apparatus, to implement transmission of the cooling medium to the transmission assembly. In some embodiments, the liquid delivery apparatus is a liquid delivery pump.

According to a second aspect, an embodiment of this application provides a compute device cluster, where the compute device cluster includes at least one cabinet, at least one energy storage apparatus is disposed in each cabinet, each energy storage apparatus includes at least one energy storage unit, and the thermal runaway management system according to the first aspect is disposed in the compute device cluster.

In the foregoing solution, the thermal runaway management system in this application is used in the compute device cluster, and can handle thermal runaway in an initial stage or re-ignition of any energy storage unit in time, so that a temperature of the energy storage unit in the compute device cluster is continuously controlled at a low level, an open flame and thermal abuse are suppressed, and occurrence and propagation of thermal runaway in the compute device cluster are effectively suppressed, thereby improving safety of the compute device cluster.

According to a third aspect, an embodiment of this application provides a data center, where the data center includes at least one compute device cluster, the compute device cluster includes at least one cabinet, at least one energy storage apparatus is disposed in each cabinet, each energy storage apparatus includes at least one energy storage unit, and the thermal runaway management system according to the first aspect is disposed in the compute device cluster.

In the foregoing solution, the thermal runaway management system according to the first aspect is used in the data center in this application, and can handle thermal runaway in an initial stage or re-ignition of any energy storage unit in time, so that a temperature of the energy storage unit in the data center is continuously controlled at a low level, an open flame and thermal abuse are suppressed, and occurrence and propagation of thermal runaway in the data center are effectively suppressed, thereby improving safety of the data center.

### BRIEF DESCRIPTION OF DRAWINGS

To describe technical solutions in embodiments of this application more clearly, the following briefly describes the accompanying drawings for embodiments. It is clear that the accompanying drawings in the following descriptions show merely some embodiments of this application, and a person of ordinary skill in the art may derive other drawings from these accompanying drawings without creative efforts.
FIG. 1 is a diagram of a structure of a data center according to an embodiment of this application;
FIG. 2 is a diagram of a structure of a compute device cluster according to an embodiment of this application;
FIG. 3 is a diagram of a structure of a thermal runaway management system disposed in a compute device cluster according to an embodiment of this application;
FIG. 4 is a diagram of an internal structure of an energy storage unit according to an embodiment of this application;
FIG. 5 is a diagram of a structure of a liquid storage apparatus according to an embodiment of this application;
FIG. 6 is a diagram of a structure of a thermal management system including a control module according to an embodiment of this application;
FIG. 7 is a diagram of a structure of another liquid storage apparatus according to an embodiment of this application;
FIG. 8 is a diagram of a structure of a sub connecting pipe according to an embodiment of this application;
FIG. 9 is a diagram of a structure of another sub connecting pipe according to an embodiment of this application;
FIG. 10 is a diagram of a structure of a second pipe according to an embodiment of this application;
FIG. 11 is a diagram of a structure of a control assembly including a fire-trace tube and a container valve according to an embodiment of this application;
FIG. 12 is a diagram of handling thermal runaway by using a control assembly and a control module according to an embodiment of this application;
FIG. 13 is a diagram of a structure of a control assembly including a temperature sensing glass ball according to an embodiment of this application;
FIG. 14 is a diagram of another structure of a control assembly including a temperature sensing glass ball according to an embodiment of this application;
FIG. 15 is a diagram of a structure of collaboration between a temperature sensing glass ball and a control module according to an embodiment of this application;
FIG. 16 is a diagram of a structure of a control assembly including a shape memory alloy according to an embodiment of this application;
FIG. 17 is a diagram of a structure of collaboration between a shape memory alloy and a control module according to an embodiment of this application;
FIG. 18 is a diagram of a structure of a thermal runaway management system including a temperature sensing module according to an embodiment of this application;
FIG. 19 is a diagram of a structure of a first regulating valve in a non-working state according to an embodiment of this application; and
FIG. 20 is a diagram of a structure of a first regulating valve in a working state according to an embodiment of this application.

In the accompanying drawings:
10: Data center;
1: Compute device cluster;
   11: Cabinet;
   12: Energy storage apparatus;
   13: Energy storage unit;
      131: Cell group; 131a: Cell;
2: Storage apparatus;
   21: Liquid storage apparatus;
   22: Gas storage apparatus;
   23: Pipe;
   24: Second regulating valve;
   25: Liquid delivery apparatus;
   26: First pressure detection apparatus;
   27: Second pressure detection apparatus;
3: Transmission assembly;
   31: Main pipe;
   32: Main connecting pipe;
   33: Sub connecting pipe;
      331: First pipe;
      332: Second pipe; 3321: Second pipe body; 3322: Second sub-pipe;
   34: Connector;
4: Control assembly;
   41: Fire-trace tube;
   42: Container valve;
   43: Temperature sensing glass ball;
   44: Shape memory alloy;
5: Control module;
6: First regulating valve;
7: Bypass valve;
8: Bypass pipe; and
9: Temperature sensing module.

### DESCRIPTION OF EMBODIMENTS

To better understand technical solutions of this application, the following describes embodiments of this application in detail with reference to the accompanying drawings.

It should be noted that described embodiments are merely some rather than all of embodiments of this application. All other embodiments obtained by a person of ordinary skill in the art based on embodiments of this application without creative efforts shall fall within the protection scope of this application.

The terms used in embodiments of this application are merely for the purpose of illustrating specific embodiments, and are not intended to limit this application. The terms "a", "said" and "the" of singular forms used in embodiments and the appended claims of this application are also intended to include plural forms, unless otherwise specified in the context clearly.

It should be understood that the term "and/or" used in this specification describes only an association relationship between associated objects and represents that three relationships may exist. For example, A and/or B may represent the following three cases: Only A exists, both A and B exist, and only B exists. In addition, the character "/" in this specification generally indicates an "or" relationship between the associated objects.

The following briefly describes concepts in embodiments of this application.

A data center is a facility dedicated to storing, processing, and distributing a large amount of data. The data center usually includes a plurality of servers, storage systems, network devices, and other related components. These components work together to support data storage, management, and computing requirements of an organization. The data center may be a physical room, a building, a facility, or the like.

A compute device cluster is usually a group of interconnected compute devices that work together as a single system to perform complex compute tasks. A device in the cluster may be a physical server, a virtual machine, or a distributed compute node, and is usually disposed inside the data center.

An energy storage apparatus is a complete energy storage system, and includes an energy storage unit and related control, management, protection, and interface devices. An objective of the energy storage apparatus is to store electric energy or energy in another form, so that the energy is released for use when needed.

An energy storage unit is a smallest module that can be independently used and that constitutes an energy storage apparatus, and is usually disposed in the energy storage apparatus. The energy storage unit usually includes a battery pack including a specific quantity of battery cells, modules, or cells, and a battery management system (Battery Management System, BMS) and a power conversion system (Power Conditioning System, PCS) that are directly connected to the battery pack. The energy storage units may operate independently, or may be combined in parallel or in series to form a larger energy storage system.

A cell is a most basic component of a battery system, and is usually a single electrochemical apparatus that is responsible for storing and releasing electric energy.

A cell group includes a plurality of cells, and is configured to provide a higher voltage and a higher capacity. The cell group usually includes several cells, a connector, a battery management system (BMS), and a shell.

A cooling medium is a substance used to transfer heat from one substance to another (usually from a device or system to another device, system, or ambient environment). In the engineering and technical fields, the cooling medium may be gas, liquid, or solid that helps control a temperature by absorbing and carrying heat, to protect a device from overheating and ensure normal operation of the device.

A fire-trace tube is a device used to automatically detect a fire source and start a fire extinguisher. The fire-trace tube usually includes a flexible tube of a non-metallic synthetic product and a semi-soft polymer material disposed in the flexible tube for fire detection. The semi-soft polymer material includes but is not limited to polytetrafluoroethylene (Polytetrafluoroethylene, PTFE), nylon, polyimide (Polyimide, PI), silicon rubber, or the like. The semi-soft polymer material can expand and burst upon being heated. A container valve is a valve used to control flow of gas or liquid, and may be mounted on a transfer pipe or a storage container to control the flow of the gas or the liquid. The container valve is usually used together with the fire-trace tube. When the fire-trace tube is heated due to a factor like a fire and reaches an operating temperature, a position with a highest temperature on the fire-trace tube softens and bursts. The burst of the fire-trace tube causes a pressure in the tube to decrease. Such a pressure change triggers opening of the connected container valve.

A temperature sensing glass ball is a glass ball that stores heat-sensitive special expansion liquid inside. The special expansion liquid is liquid with a high expansion rate that boils at a low temperature, and may be selected from, for example, ester, alcohol, and ether. A material of the glass ball may be, for example, high borosilicate glass. After the special expansion liquid reaches a specific specified temperature, the temperature sensing glass ball bursts. As a temperature near the temperature sensing glass ball increases, the special expansion liquid in the glass ball expands upon being heated, causing a pressure to increase. After a temperature of the special expansion liquid reaches the specified temperature, the temperature sensing glass ball bursts.

A shape memory alloy (Shape Memory Alloy, SMA) is a special alloy material, and has a unique physical property, namely, a shape memory effect. This effect allows the alloy to restore to an original shape at a specific temperature.

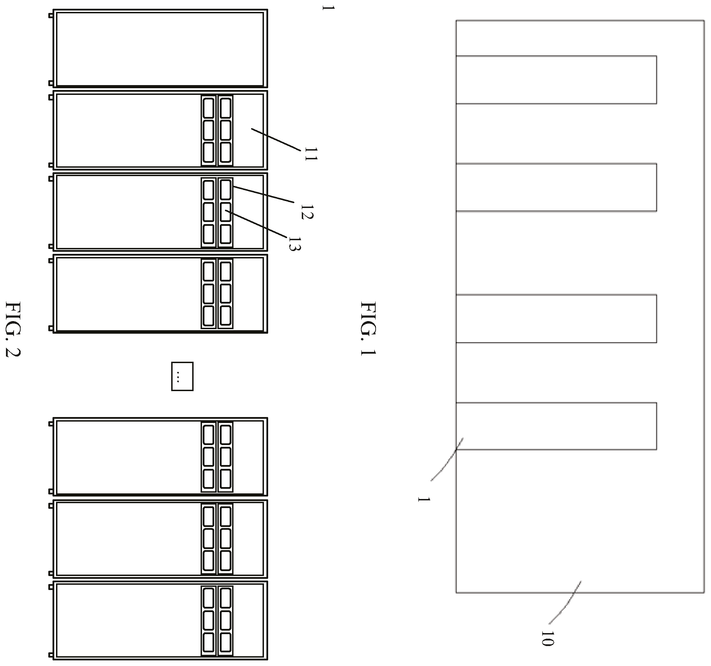

Internet service providers, enterprise platforms, research institutions, and the like all have a large amount of computing requirements. An operation platform that meets needs such as storage, computing, and networking is referred to as a data center. FIG. 1 is a diagram of a structure of a data center. Refer to FIG. 1. A plurality of compute device clusters 1 are disposed in the data center 10, to store, process, and distribute a large amount of data information. FIG. 2 is a diagram of a structure of the compute device cluster 1. Usually, a backup power supply needs to be disposed in the compute device cluster 1, and the backup power supply can provide electric energy for the compute device cluster in the data center in a case of a mains outage or the like. It may be understood that FIG. 2 shows only a part related to the backup power supply in the compute device cluster.

Still refer to FIG. 2. The compute device cluster 1 includes at least one cabinet 11, at least one energy storage apparatus 12 is disposed in each cabinet 11, at least one energy storage unit 13 is disposed in each energy storage apparatus 12, and the energy storage unit 13 may include at least one element that stores electric energy, for example, a battery or an inductor. During use of the compute device cluster 1, due to a factor of the compute device cluster 1 or an external factor, thermal runaway may occur after the energy storage unit 13 in the compute device cluster 1 reaches a specific temperature, and the energy storage unit 13 quickly releases energy in a short period of time. For example, when an external short circuit occurs in a lithium battery, a battery temperature increases rapidly at a power of several kilowatts, and reaches a thermal runaway trigger temperature within dozens of seconds. Then, a quick energy release process continues. As a result, the battery may exhaust air, catch fire, or even explode. If the thermal runaway is not suppressed, a high temperature, an open flame, or the like generated by the battery spreads inside the cabinet 11 or between the cabinets 11, causing thermal runaway of more energy storage units 13, and causing thermal runaway of the entire data center 10. The energy storage unit 13 is disposed inside the compute device cluster 1, and is further disposed inside the cabinet 11. Therefore, if spray fire extinguishing processing is simply performed outside the data center 10, outside the compute device cluster 1, or outside the cabinet 11, a sprayed working medium is in contact with only a surface of the cabinet 11 to exchange heat and block oxygen, and only has a specific function of extinguishing the open flame. The sprayed working medium cannot be effectively in contact with the energy storage unit 13, and cannot suppress the thermal runaway fundamentally. In addition, once thermal runaway occurs in the compute device cluster 1, a temperature increases rapidly in a short period of time. As a result, a local instantaneous power is extremely high, which probably causes a fire directly within seconds. The thermal runaway spreads rapidly, making the thermal runaway more difficult to handle. Consequently, a serious fire occurs in the compute device cluster 1 or even the data center 10.

In view of this, an embodiment of this application provides a thermal runaway management system. The thermal runaway management system is disposed inside the data center 10, and is further disposed in the compute device cluster 1 of the data center 10. The thermal runaway management system may directly act on the energy storage unit 13 inside the compute device cluster 1. A thermal runaway occurrence position can be quickly identified in an early stage of thermal runaway, and a suppression measure can be further taken in the early stage or an early to middle stage of the thermal runaway to prevent or slow down occurrence of the thermal runaway, thereby preventing spread of the thermal runaway. This improves use safety of the compute device cluster 1 and the data center 10, and minimizes asset losses of the compute device cluster 1 and the data center 10.

The following describes in detail the thermal runaway management system provided in embodiments of this application with reference to the specific accompanying drawings.

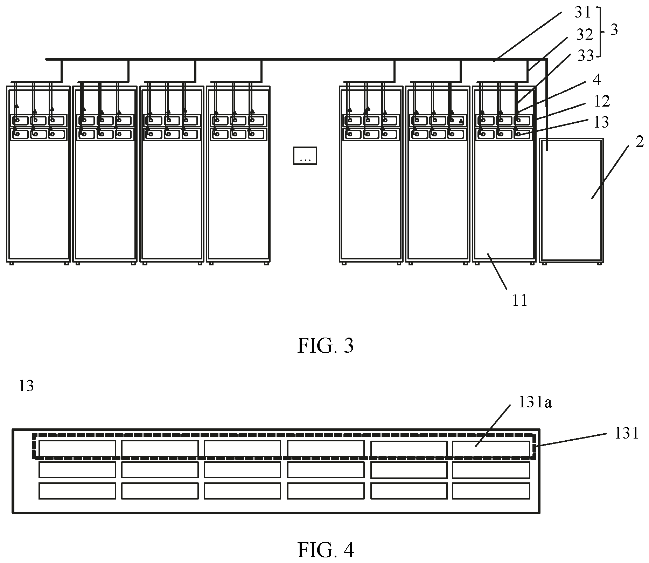

FIG. 3 is a diagram of a structure of the thermal runaway management system disposed in the compute device cluster according to an embodiment of this application. Refer to FIG. 3. The thermal runaway management system includes a storage apparatus 2, a transmission assembly 3, and a control assembly 4. The storage apparatus 2 is connected to the transmission assembly 3, the control assembly 4 is disposed on the transmission assembly 3, and the control assembly 4 is at least partially disposed inside the energy storage unit 13. The storage apparatus 2 stores a cooling medium (the cooling medium is not shown in FIG. 2). The transmission assembly 3 is configured to transfer the cooling medium in the storage apparatus 2. The control assembly 4 is at least partially disposed inside the energy storage unit 13 to detect an ambient temperature in the energy storage unit 13. The control assembly 4 is disposed on the transmission assembly 3 to control whether the cooling medium can enter the energy storage unit 13 through the transmission assembly 3. In this way, when the ambient temperature of the energy storage unit 13 is higher than or equal to a thermal runaway temperature of the energy storage unit 13, the cooling medium enters the energy storage unit 13 through the transmission assembly 3, so that thermal runaway of the energy storage unit 13 is handled by using the cooling medium. In this application, whether the cooling medium enters the energy storage unit 13 through the transmission assembly 3 and the control assembly 4 may be controlled based on the ambient temperature of the energy storage unit 13, so that thermal runaway and thermal runaway propagation can be effectively suppressed in an early stage or an early to middle stage of the thermal runaway, thereby improving use safety of the compute device cluster 1 and the data center 10.

In this application, the thermal runaway temperature of the energy storage unit 13 is set to a start temperature of self-generated heat of the energy storage unit 13. In the early stage of the thermal runaway, as the thermal runaway temperature increases to reach the start temperature of the self-generated heat, an active substance inside the energy storage unit 13 starts to have a significant exothermic reaction from this temperature. Reactions in this stage overlap and last for a long period of time. In this application, the thermal runaway temperature of the energy storage unit 13 is set to the start temperature of the self-generated heat of the energy storage unit 13, so that the thermal runaway can be handled in the early stage of the thermal runaway. In addition, sufficient time can be provided for transferring the cooling medium of the thermal runaway management system to the energy storage unit 13, to reduce a quantity of thermal runaway propagation. Optionally, the thermal runaway temperature of the energy storage unit 13 is set to 70°C. Certainly, thermal runaway threshold temperatures of energy storage units 13 of different models or materials are different. A person skilled in the art may set a thermal runaway temperature based on a specific energy storage unit 13. This is not limited in this application.

In this application, the ambient temperature of the energy storage unit 13 is a temperature of the energy storage unit 13 in a working process or a temperature of surrounding air in which the energy storage unit 13 is located.

In some implementations, FIG. 4 is a diagram of an internal structure of the energy storage unit. Refer to FIG. 4. At least one cell group 131 is disposed in each energy storage unit 13, and each cell group 131 includes at least one cell 131a. The cooling medium may be directly transferred to the cell 131a through the transmission assembly 3, to handle thermal runaway of the cell 131a, so that thermal runaway of the energy storage unit 13 can be fundamentally eliminated, and a quantity of thermal runaway propagation can be reduced. It may be understood that, in the compute device cluster 1, the cell 131a is a minimum unit for storing electric energy and supplying power.

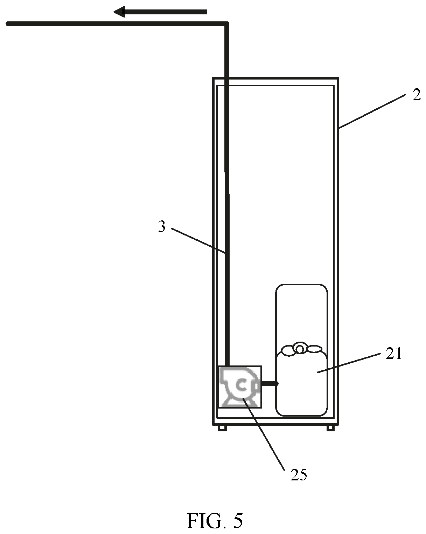

In some implementations, FIG. 5 is a diagram of a structure of a liquid storage apparatus. Refer to FIG. 5. The storage apparatus 2 includes the liquid storage apparatus 21 and the cooling medium stored in the liquid storage apparatus 21. The cooling medium is a substance that can perform heat transfer with heat generated by the energy storage unit 13 to reduce the temperature of the energy storage unit 13. In this application, the cooling medium may be, for example, a substance like perfluorohexanone, hydrofluoroether, hydrocarbon oil, silicon oil, or fluoride hydrocarbon.

In some implementations, the cooling medium in the liquid storage apparatus 21 is transmitted to the transmission assembly 3 in the following two manners.

In some embodiments, still refer to FIG. 5. A liquid delivery apparatus 25 is disposed on the transmission assembly 3. The liquid delivery apparatus 25 generates a negative pressure through a mechanical or an electric force, so that the cooling medium in the liquid storage apparatus 21 enters the transmission assembly 3 under the action of the negative pressure, to transfer the cooling medium. In some embodiments, the liquid delivery apparatus 25 includes a liquid delivery pump.

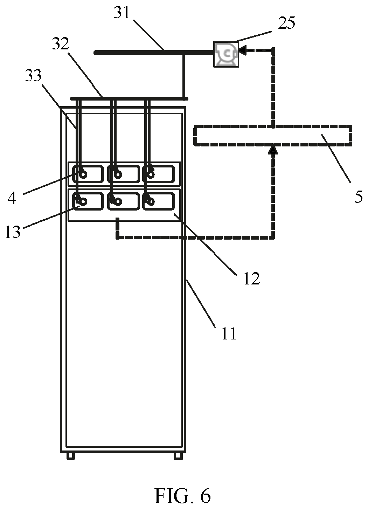

Optionally, the thermal runaway management system further includes a control module 5. FIG. 6 is a diagram of a structure of the thermal management system including the control module. Refer to FIG. 6. The control module 5 is separately connected to the control assembly 4 and the liquid delivery apparatus 25. When the ambient temperature of the energy storage unit 13 is higher than or equal to the thermal runaway temperature of the energy storage unit 13, the control assembly 4 controls the cooling medium to enter the energy storage unit 13 through the transmission assembly 3 to handle thermal runaway. In addition, the control module 5 controls opening and an opening degree of the liquid delivery apparatus 25, to control a flow volume of transmitting the cooling medium.

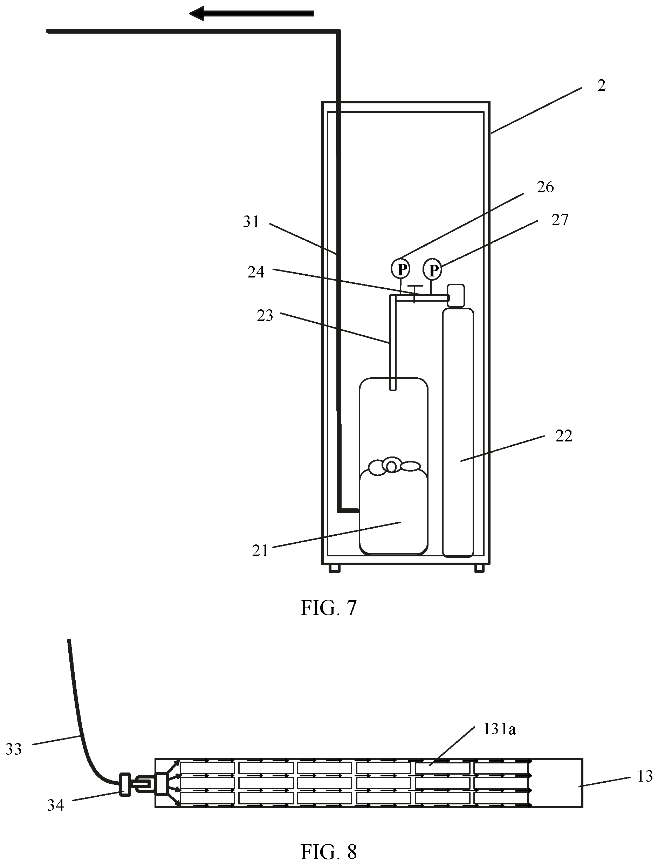

In some other embodiments, FIG. 7 is a diagram of a structure of another liquid storage apparatus. Refer to FIG. 7. The storage apparatus 2 further includes a gas storage apparatus 22. There is a specific pressure in the gas storage apparatus 22. The liquid storage apparatus 21 and the gas storage apparatus 22 are connected through a pipe 23. A pressure in the liquid storage apparatus 21 is lower than the pressure in the gas storage apparatus 22. In this way, the gas storage apparatus 22 may transfer a specific pressure to the liquid storage apparatus 21, to provide power for the cooling medium in the liquid storage apparatus 21 to enter the transmission assembly 3. Specifically, a second regulating valve 24 is disposed on the pipe 23, and the second regulating valve 24 may be, for example, a reducing valve. An opening degree of the reducing valve is adjusted to adjust the pressure transferred by the gas storage apparatus 22 to the liquid storage apparatus 21, to further adjust a magnitude of flow volume of the cooling medium in the liquid storage apparatus 21 and transferred to the transmission assembly 3.

Optionally, still refer to FIG. 7. A first pressure detection apparatus 26 and a second pressure detection apparatus 27 are further disposed on the pipe 23. The first pressure detection apparatus 26 is configured to detect a magnitude of the pressure in the liquid storage apparatus 21, and the second pressure detection apparatus 27 is configured to detect a magnitude of the pressure in the gas storage apparatus 22. The magnitude of the pressure in the liquid storage apparatus 21 can be precisely controlled through a combination of the second regulating valve 24, the first pressure detection apparatus 26, and the second pressure detection apparatus 27.

In this embodiment, a specific pressure is always maintained in the liquid storage apparatus 21, and a specific pressure difference always exists between the liquid storage apparatus 21 and the transmission assembly 3, so that the cooling medium in the liquid storage apparatus 21 can be automatically transmitted to a main pipe 31. To be specific, when heat treatment is not performed on the compute device cluster 1, a specific volume of cooling medium may also exist in the transmission assembly 3. In this way, when thermal runaway occurs in the compute device cluster 1, a distance and a time length for transmitting the cooling medium from the liquid storage apparatus 21 to the transmission assembly 3 are reduced, thereby greatly improving efficiency of handling the thermal runaway.

Optionally, the gas storage apparatus 22 stores gas of a specific pressure, for example, inert gas. The inert gas may be, for example, nitrogen. For example, a volume of the gas storage apparatus 22 is 40 L, and nitrogen of 0.95 kg is stored in the gas storage apparatus 22. A pressure P1 in the gas storage apparatus 22 is measured by using the second pressure detection apparatus 27, and is 2 MPa. The opening degree of the reducing valve is adjusted, so that a magnitude of a pressure P2 of the first pressure detection apparatus 26 is 0.1 MPa. Therefore, a pressure transferred by the gas storage apparatus 22 to the liquid storage apparatus 21 is 0.1 MPa. In other words, a pressure in the liquid storage apparatus 21 is 0.1 MPa. In this case, the pressure in the gas storage apparatus 22 changes to 1.2 MPa. In this application, the opening degree of the reducing valve can be adjusted based on a magnitude of a pressure needed in the liquid storage apparatus 21, to further adjust a flow volume of transmitting the cooling medium from the liquid storage apparatus 21 to the transmission assembly.

Still Refer to FIG. 3. The transmission assembly 3 includes the main pipe 31, a main connecting pipe 32, and a sub connecting pipe 33. There is one main pipe 31. The main pipe 31 is connected to the storage apparatus 2, so that the cooling medium in the storage apparatus 2 can enter the main pipe 31 as needed. At least one main connecting pipe 32 is connected to the main pipe 31. The main connecting pipe 32 and the energy storage apparatus 12 are in one-to-one correspondence. To be specific, the at least one main connecting pipe 32 is connected to a side of the main pipe 31, to form first hierarchical distribution of transmission. At least one sub connecting pipe 33 is connected to each main connecting pipe 32, the sub connecting pipe 33 and the energy storage unit 13 are in one-to-one correspondence, and the sub connecting pipe 33 is in communication with the inside of the energy storage unit 13. The connecting pipe assembly 32 includes at least one main connecting pipe 321, the at least one main connecting pipe 321 is separately connected to the main pipe 31, a quantity of main connecting pipes 321 corresponds to a quantity of energy storage apparatuses 12, and disposing positions of the main connecting pipes 321 are in one-to-one correspondence with positions of the energy storage apparatuses 12, to form secondary hierarchical distribution of transmission. In this application, the transmission assembly 3 is disposed, so that the cooling medium can be in contact with each energy storage unit 13 in the compute device cluster 1. When the ambient temperature detected by the control assembly 4 is higher than or equal to the thermal runaway temperature of the energy storage unit 13, it indicates that thermal runaway is about to occur or has occurred in the energy storage unit 13. In this case, the cooling medium in the storage apparatus 13 can exchange heat with the inside of the energy storage unit 13 through the transmission assembly 3, to directly handle the thermal runaway of the energy storage unit 13. In addition, in this application, the cooling medium in the storage apparatus 2 is directly transferred to the corresponding energy storage unit 13, to implement centralized pooling of the cooling medium, so that local thermal runaway of the compute device cluster 1 can be precisely handled, and a resource waste caused by spraying the cooling medium in a large area of the compute device cluster 1 is avoided.

In this application, a pipe flow volume of the main pipe 31 is greater than a pipe flow volume of the main connecting pipe 32, and the pipe flow volume of the main connecting pipe 32 is greater than a pipe flow volume of the sub connecting pipe 33. The pipe flow volumes of the main pipe 31, the main connecting pipe 32, and the sub connecting pipe 33 are not limited in this application. It only needs to be ensured that the sub connecting pipe 33 has a sufficient flow volume to handle the thermal runaway.

Optionally, FIG. 8 is a diagram of a structure of a sub connecting pipe. Refer to FIG. 8. The sub connecting pipe 33 is disposed outside the energy storage unit 13, and an end of the sub connecting pipe 33 is connected to the energy storage unit 13, so that the cooling medium in the sub connecting pipe 33 can be directly transferred to the inside of the energy storage unit 13 to be in contact with the cell 131a for heat exchange.

Optionally, still refer to FIG. 8. The thermal management system further includes a connector 34, the connector 34 is disposed on the energy storage unit 13, and the connector 34 is configured to detachably connect the sub connecting pipe 33 to the energy storage unit 13. For example, the sub connecting pipe 33 and the energy storage unit 13 are connected through the connector 34 in a threaded manner. Preferably, a connector used together with the connector 34 is disposed at the end of the sub connecting pipe 33, and the connector 34 and the connector are used together, so that the sub connecting pipe 33 and the energy storage unit 13 are detachably connected, thereby facilitating subsequent maintenance and management, and further improving sealing performance of a joint between the sub connecting pipe 33 and the energy storage unit 13.

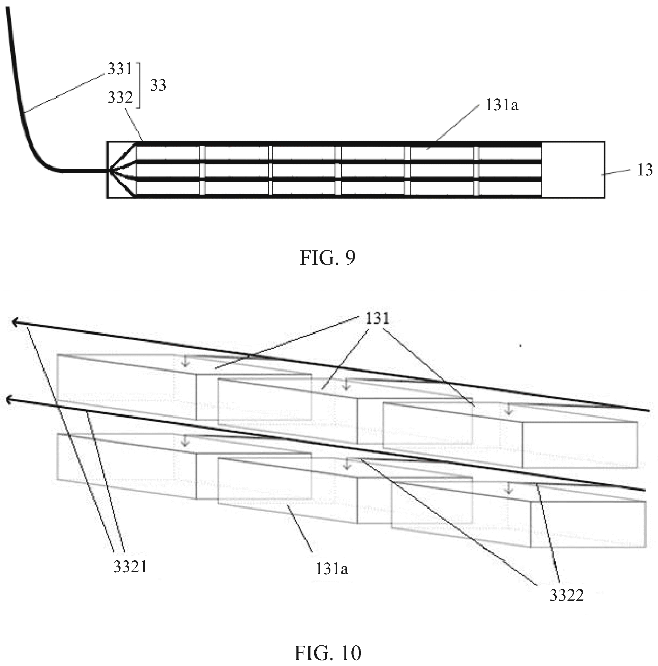

Optionally, FIG. 9 is a diagram of a structure of another sub connecting pipe. Refer to FIG. 9. The sub connecting pipe 33 includes a first pipe 331 and second pipes 332 that are connected to each other. The first pipe 331 is disposed outside the energy storage unit 13, the second pipes 332 are disposed inside the energy storage unit 13, and the second pipes 332 are in contact with any cell group 131. There are a plurality of second pipes 332, and the plurality of second pipes 332 are all connected to the first pipe 331.

In some embodiments, when no thermal runaway occurs in the energy storage unit 13, the cooling medium may be stored in the liquid storage apparatus 21 and distributed in the main pipe 31, the main connecting pipe 32, and the first pipe 331, and may be further distributed in some second pipes 332, but does not flow out of the second pipes 332. When thermal runaway occurs in any cell 131a in the energy storage unit 13, the cooling medium in the liquid storage apparatus 21 flows out from the second pipe 332 and is transferred to a surface of the cell 131a in which the thermal runaway occurs, to exchange heat and handle the thermal runaway. In this application, the first pipe 331 and the second pipe 332 are disposed, so that a thermal runaway handling position is more precise, and the thermal runaway of the energy storage unit 13 can be handled in an early stage, thereby reducing a quantity of thermal runaway propagation inside the energy storage unit 13, further reducing a quantity of thermal runaway propagation between the energy storage units 13, reducing a quantity of occurrence of an open flame, and improving efficiency of handling the thermal runaway.

Optionally, FIG. 10 is a diagram of a structure of the second pipe. Refer to FIG. 10. The second pipe 332 includes a second pipe body 3321 and at least one second sub-pipe 3322. Positions and a quantity of second pipe bodies 3321 are in one-to-one correspondence with positions and a quantity of cell groups 131. A quantity of second sub-pipes 3322 is the same as a quantity of cells 131a in the cell group 131, and positions of the second sub-pipes 3322 are in one-to-one correspondence with positions of the cells 131a. In this way, the second pipe 332 can precisely correspond to each cell 131a. When thermal runaway occurs in any cell 131a in the energy storage unit 13, the cooling medium in the liquid storage apparatus 21 can enter, through the first pipe 331 and the second pipe body 3321, a second sub-pipe 3322 in contact with the cell 131a in which the thermal runaway occurs. The cooling medium in the second sub-pipe 3322 flows through a surface of the cell 131a, and efficiently takes away heat of the cell 131a through a boiling heat exchange process, to control a temperature of the cell 131a, so that the thermal runaway of the cell 131a is fundamentally eliminated. In this application, the second sub-pipe 3322 is disposed, so that a thermal runaway handling position is further precise, the thermal runaway of the cell 131a can be handled in an early stage, and the cell 131a in which the thermal runaway occurs can be handled in a short period of time, thereby reducing heat transfer from the cell 131a in which the thermal runaway occurs to another cell module, reducing a quantity of occurrence of an open flame, and improving efficiency of handling the thermal runaway.

In this application, the control assembly 4 is used to control a status of the transmission assembly 3, to enable the transmission assembly 3 to be in an open state or a closed state. When the ambient temperature of the energy storage unit 13 is lower than the thermal runaway temperature of the energy storage unit 13, the control assembly 4 enables the transmission assembly 3 to be in the closed state. In this state, the cooling medium cannot enter the energy storage unit 13 through the transmission assembly 3. When the ambient temperature of the energy storage unit 13 is higher than or equal to the thermal runaway temperature of the energy storage unit 13, the control assembly 4 enables the transmission assembly 3 to be in the open state. In this state, the cooling medium can enter the energy storage unit 13 through the transmission assembly 3 to manage thermal runaway.

If the transmission assembly 3 is in the open state, the main pipe 31, the main connecting pipe 32, and the sub connecting pipe 33 can all allow the cooling medium to flow. If the transmission assembly 3 is in the closed state, at least one of the main pipe 31, the main connecting pipe 32, and the sub connecting pipe 33 cannot allow the cooling medium to flow. Preferably, to improve efficiency of transferring the cooling medium to the energy storage unit 13, when the transmission assembly 3 is in the closed state, the main pipe 31 and the main connecting pipe 32 can allow the cooling medium to flow, and the sub connecting pipe 33 cannot allow the cooling medium to flow.

The following describes adjustment of the status of the transmission assembly 3 by the control assembly 4 by using an example in which when the transmission assembly 3 is in the closed state, the main pipe 31 and the main connecting pipe 32 can allow the cooling medium to flow, and the sub connecting pipe 33 cannot allow the cooling medium to flow.

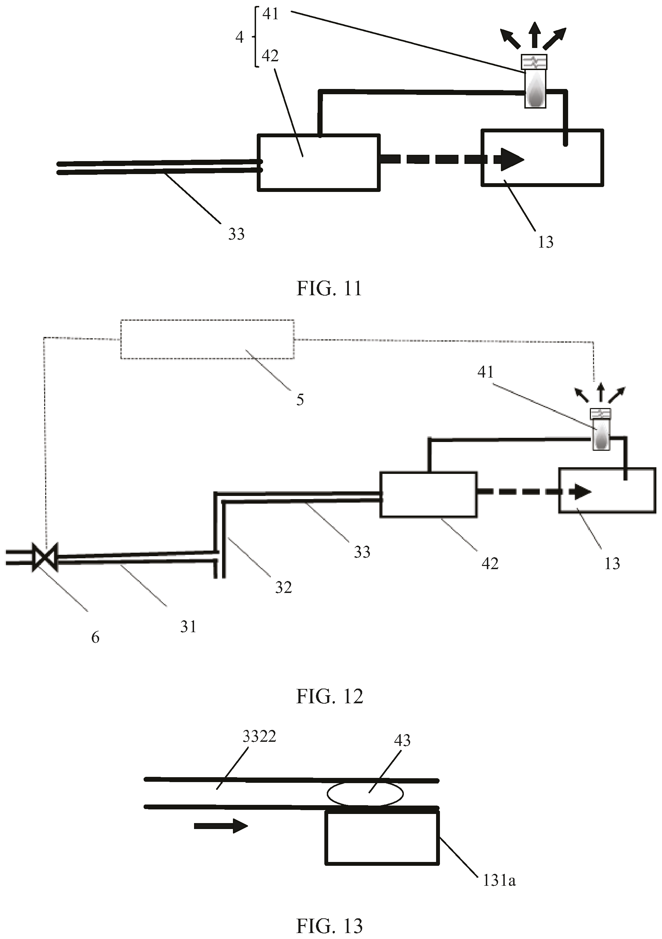

In some implementations, the control assembly 4 includes a fire-trace tube 41 and a container valve 42. FIG. 11 is a diagram of a structure of the control assembly 4. Refer to FIG. 11. One end of the fire-trace tube 41 is connected to the container valve 42, and the container valve 42 is disposed on the sub connecting pipe 33. Preferably, the container valve 42 is disposed on the second pipe 332. Further preferably, the container valve 42 is located on the second sub-pipe 3322 (FIG. 11 is only a diagram of a structure in which the container valve 42 is disposed on the sub connecting pipe 33), to implement an open state or a closed state of the sub connecting pipe 33. The other end of the fire-trace tube 41 is located inside the energy storage unit 13 and is configured to detect the ambient temperature in the energy storage unit 13.

Optionally, a material included in the fire-trace tube 41 and used for fire detection is a semi-soft polymer, and the semi-soft polymer can expand and burst upon being heated. The container valve 42 is a valve. In an initial working state, the container valve 42 includes an upper part and a lower part, and the upper part and the lower part are in a pressure balance state. A sealing structure and a rubber gasket are disposed in a body of the container valve 42 to isolate the upper part from the lower part, to further block an outlet of the container valve 42. After the fire-trace tube 41 bursts upon being heated, a pressure in the fire-trace tube 41 suddenly decreases, a pressure at an end that is of the container valve 42 and that is close to the fire-trace tube 41 also decreases. In this case, pressures of the upper part and the lower part of the container valve 42 become unbalanced, and the pressure of the lower part is higher than the pressure of the upper part. A pressure difference generated therefrom pushes the sealing structure and the rubber gasket to open, so that the container valve is open. The fire-trace tube 41 and the container valve 42 are components that can be obtained by a person skilled in the art through commercial means, and specific structures of the fire-trace tube 41 and the container valve 42 are not described in this application. It may be understood that the fire-trace tube 41 is flexible, and can extend into the energy storage unit 13 without being affected by any position.

An assembly obtained by combining the fire-trace tube 41 and the container valve 42 is mounted on the thermal runaway management system in this application. When no thermal runaway occurs (the ambient temperature of the energy storage unit 13 is lower than the thermal runaway temperature of the energy storage unit 13), a pressure in the container valve 42 is in a balanced state. Existence of the container valve 42 enables the sub connecting pipe 33 to be in the closed state. In other words, the transmission assembly 3 is in the closed state. In this case, the cooling medium cannot enter the energy storage unit 13. In other words, in this state, thermal runaway management does not need to be performed. A dashed line shown in FIG. 11 indicates that the cooling medium may enter or not enter the energy storage unit 13. When the ambient temperature of the energy storage unit 13 is higher than or equal to the thermal runaway temperature of the energy storage unit 13, the fire-trace tube 41 bursts, causing a sudden decrease of the pressure in the fire-trace tube 41. Therefore, the container valve 42 is open, to enable the sub connecting pipe 33 to be in the open state. In other words, the transmission assembly 3 is in the open state. The cooling medium is transferred to the inside of the energy storage unit 13 through the transmission assembly 3, to handle the thermal runaway of the energy storage unit 13. In this embodiment, the fire-trace tube 41 is configured to detect the ambient temperature of the energy storage unit 13, and the container valve is configured to control whether the transmission assembly 3 is open.

Optionally, when the storage apparatus 2 uses a combination of the liquid storage apparatus 21 and the gas storage apparatus 22, existence of the gas storage apparatus 22 enables the liquid storage apparatus 21 to always have a specific pressure. After the liquid storage apparatus 21 is connected to the transmission assembly 3, a specific pressure difference exists in an area that is of the main pipe 31 of the transmission assembly 3 and that is close to the liquid storage apparatus 21, to allow the cooling medium in the liquid storage apparatus 21 to enter the main pipe 31. To be specific, when no thermal runaway occurs, the cooling medium is distributed inside the main pipe 31, the main connecting pipe 32, and a part of the sub connecting pipe 33 that are of the transmission assembly 3. In this embodiment, because the cooling medium is distributed inside the transmission assembly 3 when no thermal runaway occurs, a distance and a time length for transferring the cooling medium to the energy storage unit 13 can be shortened, thereby greatly improving efficiency of transferring the cooling medium. When thermal runaway occurs in the energy storage unit 13, the control assembly 4 enables the sub connecting pipe 33 to be in the open state, so that the cooling medium can be in contact and exchange heat with the energy storage unit 13 in time, greatly improving efficiency of suppressing the thermal runaway. Optionally, the fire-trace tube 41 may be disposed around surfaces of all the cells 131a in the energy storage unit 13. To be specific, the fire-trace tube 41 may be configured to detect a temperature of all the cells 131a in the energy storage unit 13, improving precision of determining whether thermal runaway occurs in the cells 131a.

Optionally, when the fire-trace tube 41 and the container valve 42 are used as the control assembly 4, the control module 5 may not be disposed, and only the fire-trace tube 41 and the container valve 42 are used to implement temperature detection and control transmission of the cooling medium.

Optionally, the control module 5 may also be used to control a flow volume of transmitting the cooling medium from the storage apparatus 2 to the energy storage unit 13. When the control module 5 is disposed, a first regulating valve 6 may be disposed on the transmission assembly 3, and the first regulating valve 6 may be mounted on at least one of the main pipe 31, the main connecting pipe 32, and the sub connecting pipe 33. FIG. 12 is a diagram of handling thermal runaway by using the control assembly and the control module. Refer to FIG. 12. The first regulating valve 6 is mounted on the main pipe 31, and the fire-trace tube 41 and the first regulating valve 6 are separately connected to the control module 5. When no thermal runaway occurs, the pressure in the container valve 42 is in the balanced state, the container valve 42 enables the sub connecting pipe 33 to be in the closed state, and the first regulating valve 6 is closed or open. In this state, the cooling medium cannot enter the energy storage unit 13 through the transmission assembly 3. It may be understood that, when the temperature of the energy storage unit 13 is lower than the thermal runaway temperature, the first regulating valve 6 may also be in the open state. In this case, an opening degree of the first regulating valve 6 needs to be controlled to be small, and it only needs to be ensured that a specific volume of cooling medium is in the transmission assembly 3. When the ambient temperature of the energy storage unit 13 is higher than or equal to the thermal runaway temperature of the energy storage unit 13, the fire-trace tube 41 bursts, so that the container valve 42 is open, to enable the sub connecting pipe 33 to be in the open state. When the fire-trace tube 41 bursts, the control module 5 monitors the burst of the fire-trace tube 41, and the control module 5 adjusts the opening degree of the first regulating valve 6, so that the cooling medium is transferred with a proper flow volume to the energy storage unit 13, thereby suppressing thermal runaway of the energy storage unit 13.

Optionally, when the control module 5 is disposed in the thermal runaway management system, the liquid delivery apparatus 25 may be further disposed on the main pipe 31 to provide power for transferring the cooling medium. When the liquid delivery apparatus 25 is used, the liquid delivery apparatus 25 is connected to the control module 5, and the control module 5 controls on/off and an opening degree of the liquid delivery apparatus 25.

In some implementations, the control assembly 4 includes a temperature sensing element. The temperature sensing element is a device sensitive to a temperature. The temperature sensing element is disposed in the sub connecting pipe 33, and the temperature sensing element is located inside the energy storage unit 13. Preferably, the temperature sensing element is disposed in the second pipe 332. Further preferably, the temperature sensing element is disposed in the second sub-pipe 3322, to implement temperature detection inside the energy storage unit 13 and control the cooling medium to handle thermal runaway inside the energy storage unit 13.

In some embodiments, the temperature sensing element is a temperature sensing glass ball 43, and the temperature sensing glass ball 43 is disposed in the second sub-pipe 3322 to be close to the cell 131a, to improve precision of thermal runaway monitoring for the energy storage unit 13.

The temperature sensing glass ball is a glass ball that stores heat-sensitive special expansion liquid inside. The special expansion liquid is liquid with a high expansion rate that boils at a low temperature, and may be selected from, for example, ester, alcohol, and ether. A material of the glass ball may be, for example, high borosilicate glass. After the special expansion liquid reaches a specific specified temperature, the temperature sensing glass ball bursts. As a temperature near the temperature sensing glass ball increases, the special expansion liquid in the glass ball expands upon being heated, causing a pressure to increase. After a temperature of the special expansion liquid reaches the specified temperature, the temperature sensing glass ball bursts.

Optionally, a specified temperature of the temperature sensing glass ball 43 is a thermal runaway temperature of the cell 131a. The following uses an example in which the temperature sensing element is disposed in the second sub-pipe 3322 for description.

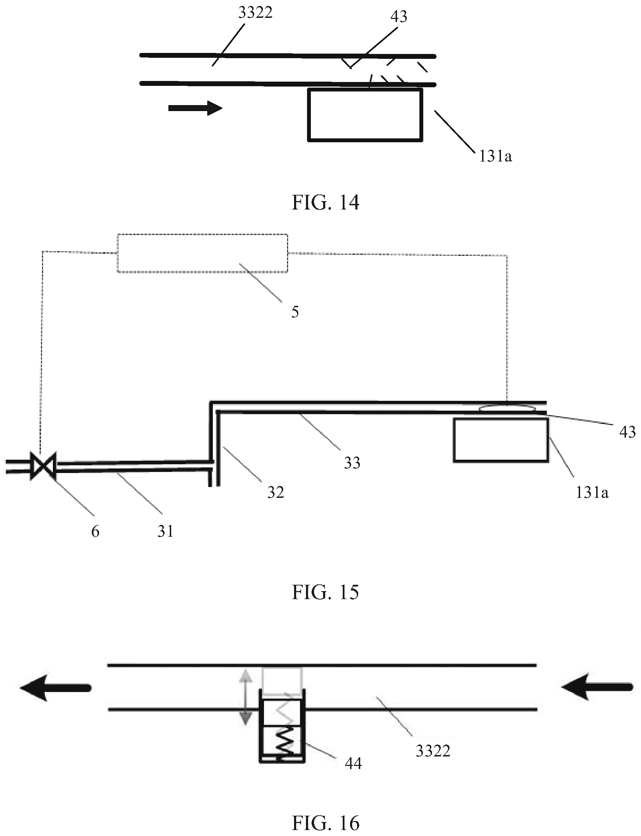

FIG. 13 is a diagram of a status of the temperature sensing glass ball 43. Refer to FIG. 13. When the temperature of the cell 131a is lower than the thermal runaway temperature, the temperature sensing glass ball 43 is disposed in the second sub-pipe 3322, to enable the second sub-pipe 3322 to be closed. In other words, the sub connecting pipe 33 is in the closed state. In this case, the cooling medium cannot enter the energy storage unit 13 through the second sub-pipe 3322. FIG. 14 is a diagram of another status of the temperature sensing glass ball. Refer to FIG. 14. When the temperature of the cell 131a is higher than or equal to the thermal runaway temperature, the temperature sensing glass ball 43 bursts, to enable the second sub-pipe 3322 to be in an open state. In other words, the sub connecting pipe 33 is in the open state. In this case, the cooling medium can enter the energy storage unit 13 through the second sub-pipe 3322, to implement heat exchange between the cooling medium and the energy storage unit 13. It may be understood that arrow directions shown in FIG. 13 and FIG. 14 are transmission directions of the cooling medium.

When the temperature sensing glass ball 43 is used as the temperature sensing element, the control module 5 may not be disposed, and only the temperature sensing glass ball 43 is used to implement temperature detection and control transfer of the cooling medium.

Optionally, the low volume of transmitting the cooling medium to the energy storage unit 13 may alternatively be controlled by additionally disposing the control module 5. When the control module 5 is disposed, the first regulating valve 6 may be disposed on the transmission assembly 3. The first regulating valve 6 may be mounted on at least one of the main pipe 31, the connecting pipe 32, and the sub connecting pipe 33. FIG. 15 is a diagram of a structure of collaboration between the temperature sensing glass ball and the control module. Refer to FIG. 15. The first regulating valve 6 is mounted on the main pipe 31, and the control module 5 is separately connected to the temperature sensing glass ball 43 and the first regulating valve 6. A sensor is disposed in the control module 5 to detect a status of the temperature sensing glass ball 43. The sensor may be, for example, an image sensor or an optical fiber sensor. When no thermal runaway occurs, existence of the temperature sensing glass ball 43 enables the sub connecting pipe 33 to be in the closed state, and the first regulating valve 6 is closed or open. When the ambient temperature of the energy storage unit 13 is higher than or equal to the thermal runaway temperature of the energy storage unit 13, the temperature sensing glass ball 43 bursts, to enable the sub connecting pipe 33 to be in the open state. When the temperature sensing glass ball 43 bursts, the control module 5 detects that the temperature sensing glass ball 43 bursts, and the control module 5 adjusts the opening degree of the first regulating valve 6, so that the cooling medium is transferred with a proper flow volume to the energy storage unit 13, thereby suppressing thermal runaway of the energy storage unit 13.

In some other embodiments, the temperature sensing element may alternatively be a shape memory alloy 44. The shape memory alloy 44 is a material including more than two metal elements and having a shape memory effect (shape memory effect, SME) through thermoelastic martensitic phase transformation and inverse transformation thereof. The shape memory alloy can deform upon being heated or under an action of an external force, and can restore to an original shape under a specific temperature condition. The shape memory alloy has a function of restoring for millions of times.

FIG. 16 is a diagram of a structure of the shape memory alloy. Refer to FIG. 16. The shape memory alloy 44 is disposed in a form similar to a valve. A deformation temperature of the shape memory alloy is set to the thermal runaway temperature of the energy storage unit 13. The following uses an example in which the shape memory alloy 44 is disposed on the second sub-pipe 3322 for description.

When a temperature of any cell 131a in the energy storage unit 13 is lower than the thermal runaway temperature, the shape memory alloy 44 is sealed inside the second sub-pipe 332, to enable the second sub-pipe 3322 to be in the closed state. When the temperature of the cell 131a is higher than or equal to the thermal runaway temperature, the shape memory alloy 44 deforms and shrinks, to enable the second sub-pipe 3322 to be in the open state. In this case, the cooling medium is in contact with the cell 131a inside the energy storage unit 13 through the second sub-pipe 3322, to implement heat exchange between the cooling medium and the energy storage unit 13, reducing the temperature of the energy storage unit 13. When the temperature of the energy storage unit 13 decreases to be lower than the thermal runaway temperature again, the shape memory alloy 44 restores to an initial shape, to enable the second sub-pipe 3322 to be in the closed state, so that heat exchange between the cooling medium and the energy storage unit 13 is blocked. In this application, the shape memory alloy can be used to implement thousands or tens of thousands of times of switching between the open state and the closed state of the second sub-pipe 3322. No consumable is used, a use quantity of the cooling medium can be reduced, and a service life of the thermal runaway management system can be further improved.

Optionally, when the shape memory alloy 44 is used as the control assembly 4, the control module 5 may not be disposed, and only the shape memory alloy 44 is used to implement temperature detection and control transmission of the cooling medium.

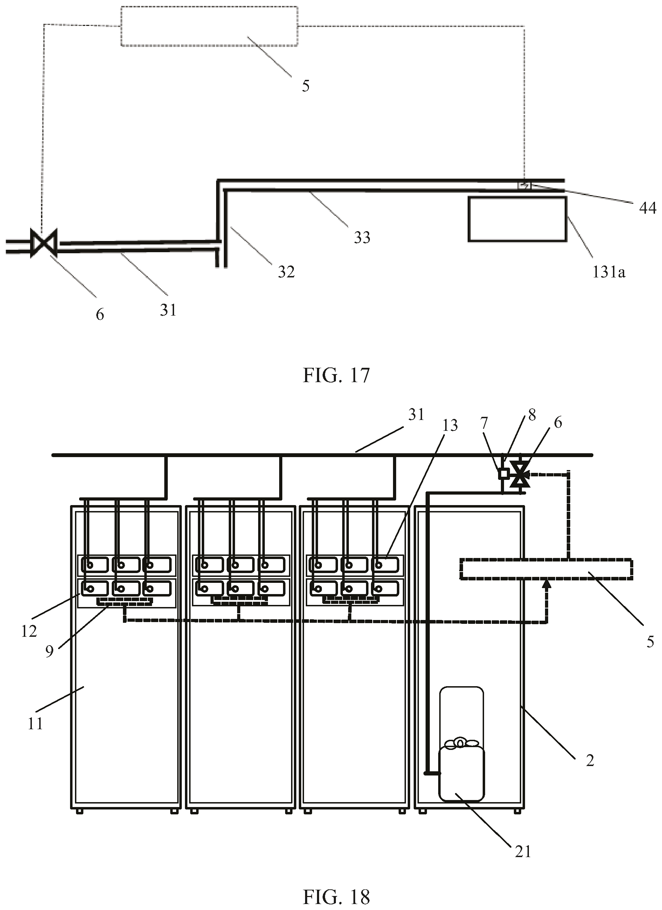

Optionally, the low volume of transmitting the cooling medium to the energy storage unit 13 may alternatively be controlled by additionally disposing the control module 5. When the control module 5 is disposed, the first regulating valve 6 may be disposed on the transmission assembly 3, and the first regulating valve 6 may be mounted on at least one of the main pipe 31, the connecting pipe 32, and the sub connecting pipe 33. FIG. 17 is a diagram of a structure of collaboration between the shape memory alloy and the control module. Refer to FIG. 17. The first regulating valve 6 is mounted on the first pipe 331, and the control module 5 is separately connected to the shape memory alloy 44 and the first regulating valve 6. A sensor is disposed in the control module 5 to detect a status of the shape memory alloy 44. The sensor may be, for example, an image sensor or an optical fiber sensor. When no thermal runaway occurs, existence of the shape memory alloy 44 enables the sub connecting pipe 33 to be in the closed state, and the first regulating valve 6 is closed or open. When the ambient temperature of the energy storage unit 13 is higher than or equal to the thermal runaway temperature of the energy storage unit 13, the shape memory alloy 44 deforms, to enable the sub connecting pipe 33 to be in the open state. At the same time, the control module 5 monitors a change of the shape memory alloy 44, and the control module 5 adjusts the opening degree of the first regulating valve 6, so that the cooling medium is transferred with a proper flow volume to the energy storage unit 13, thereby suppressing thermal runaway of the energy storage unit 13.

Optionally, the thermal runaway management system further includes a temperature sensing module 9. The temperature sensing module 9 may be used together with the control assembly 4 and the control module 5, or may be used together with the control module 5 only. For example, the temperature sensing module 9 is used together with the control assembly 4 and the control module 5. FIG. 18 is a diagram of the thermal runaway management system including the temperature sensing module. Refer to FIG. 18. The temperature sensing module 9 is disposed inside the energy storage unit 13, the first regulating valve 6 is further disposed on the transmission assembly 3, and both the temperature sensing module 45 and the first regulating valve 6 are connected to the control module 5. The temperature sensing module 9 detects the temperature of the energy storage unit 13 and transfers detected real-time temperature information to the control module 5. The control module 5 is configured to monitor a status of the control assembly 4. The control module 5 is further configured to receive the temperature information transferred by the temperature sensing module 9. When the temperature of the energy storage unit 13 is lower than the thermal runaway temperature, the first regulating valve 6 is closed or opened. In this state, the cooling medium cannot enter the energy storage unit 13 through the transmission assembly 3. When the temperature of the energy storage unit 13 is higher than or equal to the thermal runaway temperature, the control assembly 4 enables the sub connecting pipe 33 to be in the open state, and at the same time, the control assembly 4 changes. In this case, the entire transmission assembly 3 is in the open state, and the control module 5 adjusts the opening degree of the first regulating valve 6 based on the temperature information transferred by the temperature sensing module 9, to adjust a flow volume of the cooling medium in the transmission assembly 3.

Optionally, the temperature sensing module 9 may be, for example, a temperature sensor.

Optionally, a bypass valve 7 is further disposed on a side of the first regulating valve 6, and the first regulating valve 6 and the bypass valve 7 are disposed on a same pipe. To be specific, the first regulating valve 6 and the bypass valve 7 may be disposed on at least one of the main pipe 31, the main connecting pipe 321, and the sub connecting pipe 33. A bypass pipe 8 is further disposed on the transmission assembly 3, and the bypass valve 7 is disposed on the bypass pipe 8, to balance a pipe pressure of the transmission assembly 3.

Still refer to FIG. 18. The control module 5 is configured to control opening and closing of the first regulating valve 6. The control module 5 may control the opening and closing of the first regulating valve 6 by controlling a change of the control assembly 4. The control assembly 4 may be at least one of the fire-trace tube 41, the container valve 42, the temperature sensing glass ball 43, and the shape memory alloy 44.

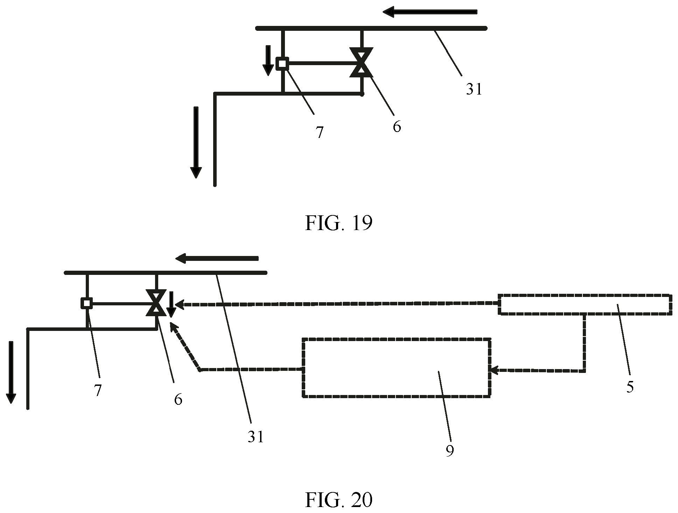

In an actual application process, the temperature sensing module 9 detects the ambient temperature in the energy storage unit 13 in real time. FIG. 19 is a diagram of a structure of the first regulating valve in a non-working state. As shown in FIG. 19, the first regulating valve 6 and the bypass valve 7 are mounted on the main pipe 31. When no thermal runaway occurs in the energy storage unit 13, the bypass valve 7 is in an always-open state, and the first regulating valve 6 is in an always-closed state. FIG. 20 is a diagram of a structure of the first regulating valve in a working state. As shown in FIG. 20, when the temperature in the energy storage unit 13 increases and reaches the thermal runaway temperature, the control module 5 calculates a flow volume of the cooling medium needed in the energy storage unit 13 based on the temperature detected by the temperature sensing module 9. The control module 5 controls the bypass valve 7 to be closed and the first regulating valve 6 to be open, and the control module 5 adjusts the opening degree of the first regulating valve 6 based on the flow volume of the cooling medium needed by the energy storage unit 13. If the first regulating valve 6 fails or a signal transferred by the temperature sensing module 9 to the control module 5 is blocked, the cooling medium may be transmitted to the inside of the energy storage unit 13 through the bypass pipe 8 that is always open. In this case, the flow volume of transmitting the cooling medium to the energy storage unit 13 cannot be adjusted quantitatively based on an actual situation, and the transmission assembly 3 supplies the cooling medium based on a maximum needed flow volume.

In conclusion, in this application, detection of the temperature of the energy storage unit 13 and transfer (passively triggered) of the cooling medium to the inside of the energy storage unit 13 can be implemented by disposing only the control assembly 4, or the detection of the temperature of the energy storage unit 13 and transfer (in a manner of combining active triggering and passive triggering) of the cooling medium to the inside of the energy storage unit 13 can be implemented by disposing the control assembly 4 and the control module 5. In addition, in this application, the storage apparatus 2 is used to store the cooling medium in a centralized manner, and the cooling medium is transmitted to the energy storage unit 13 in a distributed manner through the transmission assembly 3, so that a needed storage volume of the cooling medium can be minimized. In this application, a storage volume of the cooling medium in the storage apparatus 2 may correspond to a volume needed for thermal runaway of one or two energy storage apparatuses 12. In addition, the transmission assembly 3 is arranged in a distributed manner, so that the cooling medium can be precisely transferred to a position of an abnormal module of the energy storage unit 3, to prevent and handle thermal runaway of the compute device cluster 1 in a point-to-point manner.

An embodiment of this application further provides a compute device cluster. The compute device includes the foregoing thermal runaway management system. A device chassis includes: a bus, a processor, a memory, and a communication interface. The processor, the memory, and the communication interface communicate through the bus. A compute device may be a server or a terminal device. It should be understood that quantities of processors and memories of the compute device are not limited in this application.

The bus may be a peripheral component interconnect (peripheral component interconnect, PCI) bus, an extended industry standard architecture (extended industry standard architecture, EISA) bus, or the like. Buses may be classified into an address bus, a data bus, a control bus, and the like. The bus may include a path for information transfer between various components (for example, the memory, the processor, and the communication interface) of the compute device.

The processor may include any one or more of processors such as a central processing unit (central processing unit, CPU), a graphics processing unit (graphics processing unit, GPU), a microprocessor (microprocessor, MP), or a digital signal processor (digital signal processor, DSP).

The memory may include a volatile memory (volatile memory), for example, a random access memory (random access memory, RAM). The memory may further include a non-volatile memory (non-volatile memory), for example, a read-only memory (read-only memory, ROM), a flash memory, a hard disk drive (hard disk drive, HDD), or a solid-state drive (solid-state drive, SSD).

The communication interface implements communication between the compute device and another device or a communication network by using a transceiver module, for example, but not limited to a network interface card or a transceiver.

The compute device may be of a product type like a computer or a server, and is particularly applicable to a data center server with a high power, a high integration degree, and an ultra-large scale. Based on an operation mechanism of a phase-change immersed liquid cooling system, an internal space expansion capability in corresponding cooling circulation may be met. In addition, a provided coolant circulation condensation function and a coolant supply function provide a technical support for reliable application of phase-change immersed liquid cooling in heat dissipation processing of a corresponding device.

An embodiment of this application further provides a data center. The foregoing compute device cluster is disposed in the data center, and the compute device includes the foregoing thermal runaway management system. The data center further includes a building configured to accommodate the compute device cluster, and a power supply and distribution system, a cooling system, a safety system, a management system, and a network device that are disposed inside the building. Data between the foregoing systems and apparatuses is transmitted through the network device.

The building may be a facility like an equipment room, a container, a commercial building, or underground space, to ensure efficient and stable running of the data center.

The power supply and distribution system includes devices such as an uninterruptible power supply (Uninterruptible Power Supply, UPS), a generator set, and a power distribution cabinet, to ensure stable power supply for the data center.

The cooling system may include an air-cooled air conditioning system. For example, the air-cooled air conditioning system implements overall cooling in the data center by connecting an air-cooled unit, an indoor end device (a fan coil), an expansion water tank, a cooling pipe, a chilled water pump, a gate valve assembly, and a pressure gauge to each other. The cooling system further includes a liquid cooling system. The liquid cooling system can use liquid as a cooling medium, and may be disposed inside a system, a server, or the like in the data center to implement precise cooling.

The safety system includes but is not limited to a fire extinguishing system, a monitoring system, and an access control system, to ensure physical safety and data safety of the data center.

The management system may be a data center infrastructure management (Data Center Infrastructure Management, DCIM) system, and monitors, manages, and optimizes a physical facility, a network, a storage device, a server, a power supply, and the cooling system of the data center. The data center infrastructure management system helps a data center administrator better understand performance and a status of the data center, improving reliability and efficiency of the data center. The network device may be a switch, a router, an optical fiber, or the like, and is mainly used for data transmission between servers in the data center and data transmission between the server and another external device (for example, a client).

The data center may centrally store, manage, process, and distribute data, and is particularly applicable to centralized data management with a large scale and comprehensive functions. In this application, the thermal runaway management system is disposed inside the data center, so that a thermal runaway risk of the data center can be effectively managed, safety and reliability of the data center are ensured, energy efficiency is improved, and an operation cost is reduced.

For same or similar parts of embodiments of this specification, refer to each other. Especially, apparatus and terminal embodiments are basically similar to method embodiments, and therefore are described briefly. For related parts, refer to descriptions in the method embodiments.

## Claims

1. A thermal runaway management system, wherein the thermal runaway management system is disposed in a compute device cluster (1), the compute device cluster (1) comprises at least one cabinet (11), at least one energy storage apparatus (12) is disposed in each cabinet (11), each energy storage apparatus (12) comprises at least one energy storage unit (13), and the thermal runaway management system comprises:
a storage apparatus (2), wherein a cooling medium is stored in the storage apparatus (2);
a transmission assembly (3), wherein the transmission assembly (3) comprises a main pipe (31), the main pipe (31) is connected to the storage apparatus (2), at least one main connecting pipe (32) is connected to the main pipe (31), the main connecting pipe (32) and the energy storage apparatus (12) are in one-to-one correspondence, at least one sub connecting pipe (33) is connected to each main connecting pipe (32), the sub connecting pipe (33) and the energy storage unit (13) are in one-to-one correspondence, and the sub connecting pipe (33) is connected to the energy storage unit (13); and
a control assembly (4), wherein the control assembly (4) is disposed on the transmission assembly (3), and the control assembly (4) is at least partially disposed inside the energy storage unit (13), to allow the cooling medium to enter the energy storage unit (13) through the transmission assembly (3) when an ambient temperature of the energy storage unit (13) is higher than or equal to a thermal runaway temperature of the energy storage unit (13).

2. The thermal runaway management system according to claim 1, wherein when the ambient temperature of the energy storage unit (13) is lower than the thermal runaway temperature of the energy storage unit (13), the control assembly (4) enables the transmission assembly (3) to be in a closed state; or
when the ambient temperature of the energy storage unit (13) is higher than or equal to the thermal runaway temperature of the energy storage unit (13), the control assembly (4) enables the transmission assembly (3) to be in an open state.

3. The thermal runaway management system according to claim 1, wherein the control assembly (4) comprises a fire-trace tube (41) and a container valve (42), the container valve (42) is disposed on the sub connecting pipe (33), one end of the fire-trace tube (41) is connected to the container valve (42), and the other end of the fire-trace tube (41) is disposed inside the energy storage unit (13).

4. The thermal runaway management system according to claim 3, wherein the energy storage unit (13) comprises at least one cell group (131), the cell group (131) comprises at least one cell (131a), and the fire-trace tube (41) is disposed on a surface of the at least one cell (131a).

5. The thermal runaway management system according to any one of claims 1 to 4, wherein the sub connecting pipe (33) comprises a first pipe (331) and a second pipe (332) that are connected to each other, the first pipe (331) is disposed outside the energy storage unit (13), and the second pipe (332) is disposed inside the energy storage unit (13).

6. The thermal runaway management system according to claim 5, wherein the control assembly (4) comprises a temperature sensing element, and the temperature sensing element is disposed inside the second pipe (332), wherein
when the ambient temperature of the energy storage unit (13) is lower than the thermal runaway temperature of the energy storage unit (13), the temperature sensing element is sealed inside the second pipe (332), to enable the second pipe (332) to be in a closed state; or
when the ambient temperature of the energy storage unit (13) is higher than or equal to the thermal runaway temperature of the energy storage unit (13), the temperature sensing element changes, to enable the second pipe (332) to be in an open state.

7. The thermal runaway management system according to claim 6, wherein the temperature sensing element comprises a temperature sensing glass ball (43) and/or a shape memory alloy (44).

8. The thermal runaway management system according to any one of claims 1 to 7, wherein the thermal runaway management system further comprises a connector (34), the connector (34) is disposed on the energy storage unit (13), and the sub connecting pipe (33) and the energy storage unit (13) are detachably connected through the connector (34).

9. The thermal runaway management system according to any one of claims 1 to 8, wherein the thermal runaway management system further comprises a control module (5) and a first regulating valve (6), the control module (5) is separately connected to the control assembly (4) and the first regulating valve (6), and the first regulating valve (6) is disposed on at least one of the main pipe (31), the main connecting pipe (32), and the sub connecting pipe (33).

10. The thermal runaway management system according to claim 9, wherein the thermal runaway management system further comprises a temperature sensing module (9), the temperature sensing module (9) is disposed inside any energy storage unit (13), and the temperature sensing module (9) is connected to the control module (5).

11. The thermal runaway management system according to any one of claims 1 to 10, wherein the storage apparatus (2) comprises a liquid storage apparatus (21), the cooling medium is disposed in the liquid storage apparatus (21), and the liquid storage apparatus (21) is connected to the main pipe (31).

12. The thermal runaway management system according to claim 11, wherein the storage apparatus (2) further comprises a gas storage apparatus (22), the gas storage apparatus (22) and the liquid storage apparatus (21) are connected to each other through a pipe (23), a second regulating valve (24) is disposed on the pipe (23), there is a first pressure in the gas storage apparatus (22), there is a second pressure in the liquid storage apparatus (21), and the first pressure is higher than the second pressure.

13. The thermal runaway management system according to claim 11, wherein a liquid delivery apparatus (25) is disposed on the main pipe (31), and the liquid delivery apparatus (25) is configured to extract the cooling medium in the storage apparatus (2).

14. A compute device cluster, wherein the compute device cluster comprises at least one cabinet (11), at least one energy storage apparatus (12) is disposed in each cabinet (11), each energy storage apparatus (12) comprises at least one energy storage unit (13), and the thermal runaway management system according to any one of claims 1 to 13 is disposed in the compute device cluster.

15. A data center, wherein the data center comprises at least one compute device cluster (1), the compute device cluster (1) comprises at least one cabinet (11), at least one energy storage apparatus (12) is disposed in each cabinet (11), each energy storage apparatus (12) comprises at least one energy storage unit (13), and the thermal runaway management system according to any one of claims 1 to 13 is disposed in the compute device cluster (1).
